# EUROPEAN PATENT APPLICATION

(11) **EP 2 677 392 A2**
(43) Date of publication of application: **25.12.2013**
(21) Application number: 13171472.7
(22) Date of filing: 11.06.2013
(51) Int. Cl.: G06F 1/18

(54) **Memory Apparatus and Electronic Apparatus**

(30) Priority: 18.06.2012 KR 20120065117; 23.04.2013 KR 20130044942
(71) Applicant: Samsung Electronics Co., Ltd, Gyeonggi-do 443-742 (KR)
(72) Inventor: Koo, Ja-goun, Seoul (KR)
(74) Representative: Walaski, Jan Filip

(57) **Abstract**

A memory apparatus comprising a circuit board, a memory portion having a plurality of memory chips arranged on the circuit board, a terminal to provide an interface between an electronic apparatus and the plurality of memory chips being arranged on a first side of the circuit board, and a connecting portion connected to a fixing unit of the electronic apparatus to fix the memory apparatus to the electronic apparatus, the connecting portion being arranged on a second side of the circuit board so as to face the terminal.

## Description

The present invention relates to a memory apparatus and an electronic apparatus, and more specifically, to a memory apparatus and a small size electronic apparatus.

Laptop computers generally refer to notebook-like computers which are conveniently carried around and used by individual users. Recently, the 'Thin & Light' features of laptop PCs or tablet type products are increasingly emphasized.

With the increase of 'Thin & Light' tendency and implementation of high-speed and high-integration memory technologies, need for improvement of the memory modules for PCs that have been applied until now, and also possibilities for the technological and economical improvements have been suggested.

Further, owing to implementation of high speed memory module, radio frequency interference (RFI) noises that may occur along the operation of the memory become more problematic compared to the past. Thus, a method is necessary, which can solve RFI noise problem.

The present general inventive concept overcomes the above disadvantages and other disadvantages not described above. Also, the present general inventive concept is not required to overcome the disadvantages described above, and an exemplary embodiment of the present general inventive concept may not overcome any of the problems described above.

A technical objective of the present general inventive concept is to provide a memory apparatus and an electronic apparatus having a small size.

Another technical objective of the present general inventive concept is to provide a memory apparatus and an electronic apparatus which reduce radio frequency interference (RFI) noises that may occur in the memory apparatus.

Additional features and utilities of the present general inventive concept will be set forth in part in the description which follows and, in part, will be obvious from the description, or may be learned by practice of the general inventive concept.

The foregoing and/or other features and utilities of the present general inventive concept are achieved by providing a memory apparatus mounted on an electronic apparatus , the memory apparatus comprising a circuit board, a memory portion comprising a plurality of memory chips arranged on the circuit board, a terminal arranged on a first side of the circuit board to provide an interface between the electronic apparatus and the plurality of memory chips, and a connecting portion arranged on a second side of the circuit board to face the terminal, the connecting portion being connected to a fixing unit of the electronic apparatus to fix the memory apparatus to the electronic apparatus and which is arranged on the other side of the circuit board so as to face the terminal.

The circuit board may have horizontal length of 50 mm to 60 mm and a vertical length of 15 mm to 25 mm.

The thickness of the memory portion and the circuit board where the memory portion is arranged may be 3 mm to 4 mm.

The terminal may include a first terminal comprising a plurality of terminals spaced apart at uniform intervals on an upper portion of the circuit board, and a second terminal comprising a plurality of terminals spaced apart at uniform intervals on an upper portion of the circuit board.

The interval between the plurality of terminals of the first terminal, and the interval between the plurality of terminals of the second terminal, may be 0.5 mm, respectively.

The first terminal and the second terminal may be spaced apart from each other.

The first terminal and the second terminal may be intervened with a groove formed therebetween.

An interval between a terminal of the first terminal and an adjacent terminal of the second terminal may be the same interval as the interval between the plurality of terminals of the first terminal.

The terminal may include a plurality of terminals and the plurality of terminals are 170 to 200 terminals.

The connecting portion may be implemented as a groove of a preset size on the second side of the circuit board.

Position of the connecting portion may correspond to types of memory modules attachable to the electronic apparatus.

The plurality of memory chips may be arranged on the same side surface of the circuit board.

The plurality of memory chips may be arranged on both side surfaces of the circuit board.

The memory apparatus may additionally include a shield which seals an upper portion of the circuit board.

The shield may be formed from a metal.

The foregoing and/or other features and utilities of the present general inventive concept may also be achieved by providing a memory apparatus mounted to an electronic apparatus, the memory apparatus comprising a circuit board, a memory portion comprising a plurality of memory chips arranged on the circuit board, and a terminal arranged on a first side of the circuit board to provide an interface between the electronic apparatus and the plurality of memory chips. The circuit board may have horizontal length of 50 mm to 60 mm and vertical length of 15 mm to 25 mm.

The foregoing and/or other features and utilities of the present general inventive concept may also be achieved by providing an electronic apparatus to or from which a memory module is attachable or detachable, the electronic apparatus including a socket comprising a plurality of terminals connected electrically to the memory module, and a fixing unit to fix the memory module to the electronic apparatus. The fixing unit is arranged opposite to the socket with reference to the memory module.

The plurality of terminals may include a first terminal comprising a plurality of terminals spaced apart at uniform intervals on a first side of the socket, and a second terminal comprising a plurality of terminals spaced apart at uniform intervals on a second side of the socket.

The interval between the plurality of terminals of the first terminal, and the interval between the plurality of terminals of the second terminal, may be 0.5 mm, respectively.

The first terminal and the second terminal may be spaced apart from each other.

An interval between a terminal of the first terminal and an adjacent terminal of the second terminal may be the same interval as the interval between the plurality of terminals of the first terminal.

Position of the fixing unit may correspond to types of memory modules attachable to the electronic apparatus.

The electronic apparatus may additionally include a shield to prevent noises of the memory module from entering the electronic apparatus.

The shield may be formed from a metal.

The shield may be separable from the electronic apparatus and fixed by the fixing unit.

The electronic apparatus may additionally include a plurality of memory chips arranged between the socket and the fixing unit.

The foregoing and/or other features and utilities of the present general inventive concept may also be achieved by providing an electronic apparatus to or from which a memory module is attachable or detachable, the electronic apparatus comprising a socket comprising a plurality of terminals connected electrically to the memory module, a fixing unit to fix the memory module to the electronic apparatus, and a shield to remove noises of the memory module. The shield may be separable from the electronic apparatus and fixed by the fixing unit.

The foregoing and/or other features and utilities of the present general inventive concept may also be achieved by providing an electronic apparatus to or from which a memory module is attachable or detachable, the electronic apparatus comprising a socket including a plurality of terminals connected electrically to the memory module, a fixing unit to fix the memory module to the electronic apparatus, and a shield to remove noises of the memory module. Further, the shield may be separated from the electronic apparatus and fixed by the fixing unit.

The foregoing and/or other features and utilities of the present general inventive concept may also be achieved by providing a memory apparatus comprising a circuit board; a plurality of memory chips mounted on the circuit board; a terminal portion disposed on a first side of the circuit board and comprising a plurality of terminals to provide an interface between the memory apparatus and an electronic apparatus; and a connecting portion disposed on a second side of the circuit board and arranged to removably connect with a fixing unit of the electronic apparatus to fix the memory apparatus to, or remove the memory apparatus from, the electronic apparatus.

The terminal portion may comprise a first terminal portion comprising a plurality of terminals, a second terminal portion comprising a plurality of terminals, and a key area separating the first terminal portion from the second terminal portion to divide types of memory apparatuses.

The circuit board may include an edge groove to indicate a direction of arranging the circuit board on the electronic apparatus.

The memory apparatus may further comprise a shield to seal the plurality of memory chips on the circuit board to reduce radio frequency interference (RFI) noises between the memory apparatus and the electronic apparatus such that the shield is fixed to the memory apparatus via the fixing unit.

The shield may be removably secured to a single side surface of the circuit board or two shields are provided to be removably secured to both side surfaces of the circuit board, respectively.

The electronic apparatus may comprise a shield removably secured to a main board of the electronic apparatus to seal the plurality of memory chips on the circuit board to reduce radio frequency interference (RFI) noises between the memory apparatus and the electronic apparatus such that the shield is fixed to the memory apparatus via the fixing unit.

The first side of the circuit board may be removably into a socket of the electronic apparatus and the second side of the circuit board may be removably secured to a main board of the electronic apparatus by the fixing unit of the electronic apparatus.

The foregoing and/or other features and utilities of the present general inventive concept may also be achieved by providing an electronic apparatus comprising a circuit board including a socket and a fixing unit; and a memory module having a first side arranged to be removably inserted into the socket and a second side arranged to be removably secured to the electronic apparatus via the fixing unit.

These and/or other features and utilities of the present general inventive concept will become apparent and more readily appreciated from the following description of the embodiments, taken in conjunction with the accompanying drawings of which:
FIG. 1 is a block diagram of an electronic apparatus according to an embodiment of the present general inventive concept;
FIG. 2 illustrates a circuit board (or a main board) of an electronic apparatus according to a first embodiment of the present general inventive concept;
FIG. 3 illustrates a circuit board of an electronic apparatus according to a second embodiment of the present general inventive concept;
FIG. 4 illustrates a circuit board of a memory module according to a first embodiment of the present general inventive concept;
FIG. 5 illustrates a circuit board of a memory module according to a second embodiment of the present general inventive concept;
FIG. 6 illustrates a circuit board of a memory module according to a third embodiment of the present general inventive concept;
FIG. 7 illustrates a circuit board of a memory module according to a fourth embodiment of the present general inventive concept;
FIG. 8 illustrates a circuit board of a memory module according to a fifth embodiment of the present general inventive concept;
FIG. 9 illustrates operation of a connection portion of a memory module according to an embodiment of the present general inventive concept;
FIGS. 10 to 12 illustrate operation of connecting memory module and an electronic apparatus according to embodiments of the present general inventive concept;
FIG. 13 illustrates an example of forming a shield in a memory module according to an embodiment of the present general inventive concept; and
FIG. 14 illustrates an example of forming a shield in an electronic apparatus according to an embodiment of the present general inventive concept.

Reference will now be made in detail to the embodiments of the present general inventive concept, examples of which are illustrated in the accompanying drawings, wherein like reference numerals refer to the like elements throughout. The embodiments are described below in order to explain the present general inventive concept while referring to the figures.

In the following description, same drawing reference numerals are used for the same elements even in different drawings. The matters defined in the description, such as detailed construction and elements, are provided to assist in a comprehensive understanding of the present general inventive concept. Accordingly, it is apparent that the embodiments of the present general inventive concept can be carried out without those specifically defined matters. Also, well-known functions or constructions are not described in detail since they would obscure the invention with unnecessary detail.

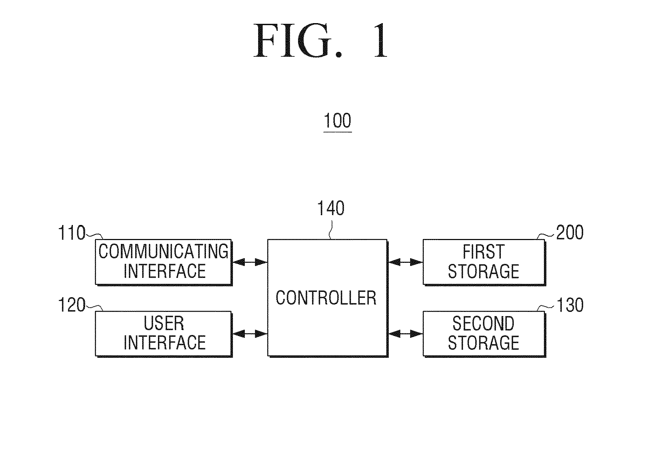

FIG. 1 is a block diagram of an electronic apparatus according to an embodiment of the present general inventive concept.

Referring to FIG. 1, an electronic apparatus 100 may include a communicating interface 110, a user interface 120, a first storage 200, a second storage 130, and a controller 140. The electronic apparatus 100 may be PCs, laptops, or tablet PCs that can expand memory.

The communicating interface 110 may be formed to connect the electronic apparatus 100 to external apparatuses (not illustrated), and may be connected to the external apparatuses with wireless communication (e.g., GSM, UMTS, LTE, WiBRO) methods as well as Local Area Network (LAN) and internet network.

The user interface 120 may include various function keys with which a user can set or select various functions provided from the electronic apparatus 100, and display various information provided from the electronic apparatus 100. The user interface 120 may be implemented as a device for simultaneously implementing input and output such as a touch pad, or a device combining functions of a mouse and a monitor.

The first storage 200 is a memory device which stores program commands and data necessary for the controller 140 during the operation of the electronic apparatus 100. The first storage 200 may directly access recorded location to read and write according to a command by a central processing unit. The first storage 200 may be implemented to be fixed on a main board of the electronic apparatus 100, or to be detachable, or to be combined with fixed and detachable forms.

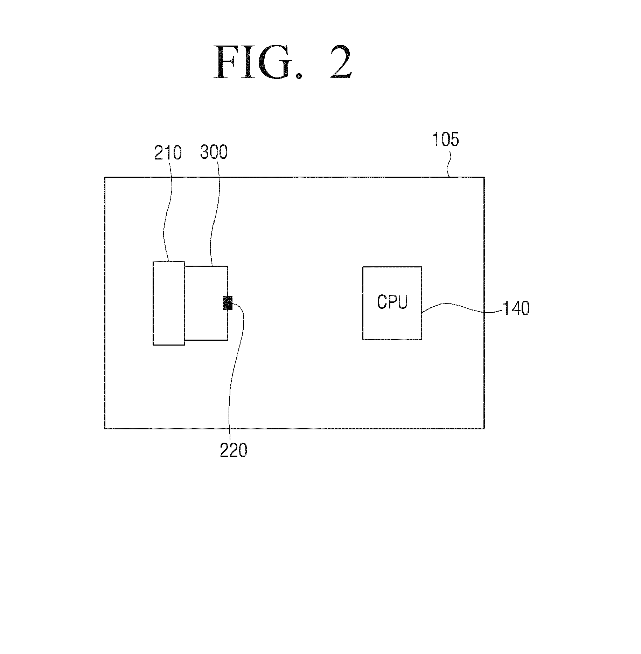

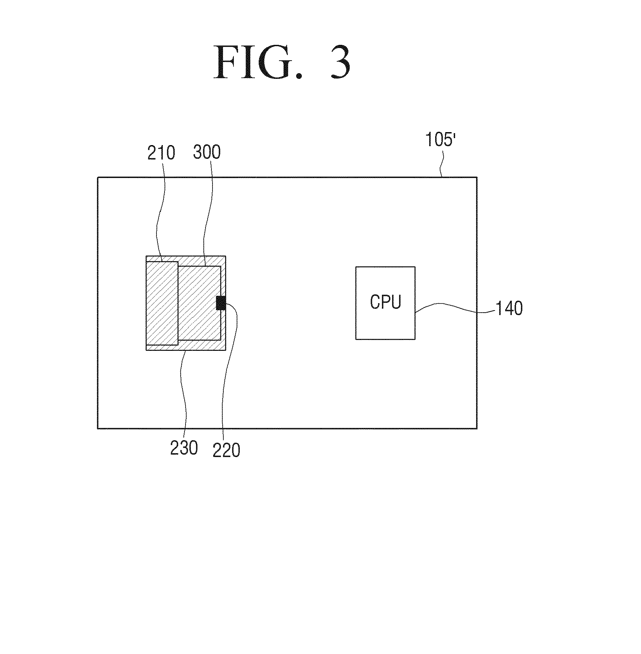

Specifically, if the first storage 200 is detachable or combined type, a main board of the electronic apparatus 100 may include a socket to interface with memory device (hereinafter, "memory module") and a fixing unit to fix the memory module. Further explanations will follow by referring to FIGS. 2 and 3.

The second storage 130 may store programs to drive the electronic apparatus 100. Specifically, the second storage 130 may store a program which is a class of various command languages necessary during operation of the electronic apparatus 100. The second storage 130 may be ROM, HDD, or SDD.

The controller 140 controls the respective constituents of the electronic apparatus 100. Specifically, if a command to turn on is inputted and power is on, the controller 140 copies O/S stored in the second storage 130 to the first storage 200 according to the commands stored in an interior ROM, implements O/S, and boots the system. If booting completes, the controller 140 may perform services corresponding to a user command through the user interface 120.

Since the electronic apparatus according to an embodiment of the present general inventive concept utilizes a memory module having a small size, the electronic apparatus may be implemented with thinner and lighter designs.

Further, the electronic apparatus according to an embodiment of the present general inventive concept may reduce radio frequency interference (RFI) noises that can occur by a memory module because the electronic apparatus includes a shield in the memory module or in an interior component.

FIG. 2 illustrates a circuit board (hereinafter, "main board") of an electronic apparatus according to a first embodiment of the present general inventive concept.

Referring to FIG. 2, a main board 105 includes a socket 210 and a fixing unit 220.

The socket 210 includes a plurality of terminals to connect to a memory module 300 electrically. Specifically, the socket 210 may include a plurality of terminals so that respective components of the electronic apparatus 100 may access the memory module 300, and power is supplied to the memory module 300. If the socket 210 is compatible with conventional SO-DIMM, the number of a plurality of terminals may be 204. If the socket 210 is compatible with a new standard, which will be described below, the number of the plurality of terminals may be in a range of 170 to 200(more specifically, the number of the terminals may be in a range of 170 to 185 or 185 to 200). Because a plurality of terminals of the socket 210 may be placed to correspond to a plurality of terminals of the memory module 300, the form of arrangement of the terminals of the socket 210 will not be described in detail for the sake of brevity.

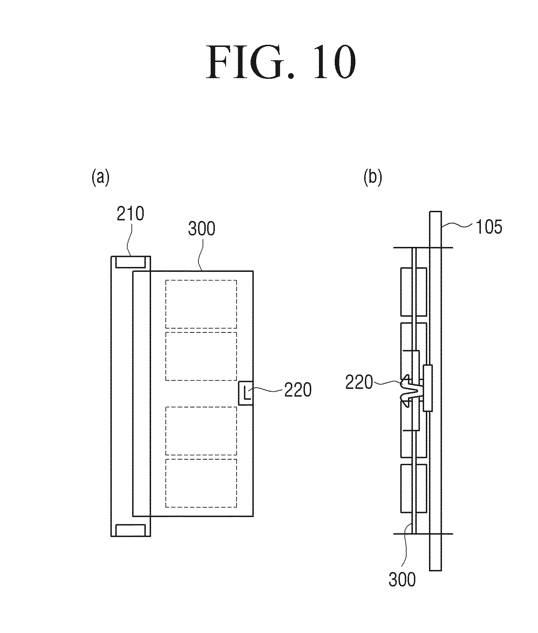

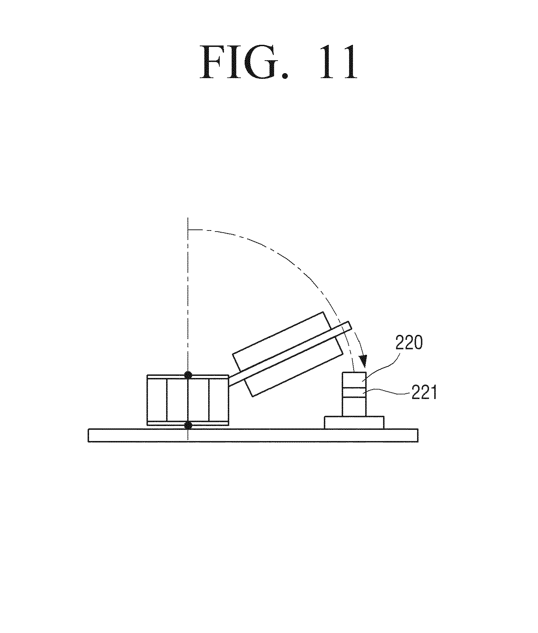

The fixing unit 220 may fix the memory module 300 to the electronic apparatus. The fixing unit 220 may be placed on position corresponding to types of memory modules that can be mounted to the electronic apparatus 100. The fixing unit 220 may perform functions of a conventional latch structure and key structure to fix memory devices. Since the fixing unit 220 may simultaneously perform functions of the above two conventional structures, less space is occupied by the memory module. Detailed shape of the fixing unit 220 will be explained below by referring to FIGS. 10 and 11.

Meanwhile, although FIG. 2 illustrates that the socket 210 and the fixing unit 220 are arranged on the same side of the main board 105 as the controller 140, the socket 210 and the fixing unit 220 may be arranged on the other side of the main board 105 that is different from the side where the controller 140 is arranged.

FIG. 3 illustrates a circuit board of an electronic apparatus according to a second embodiment of the present general inventive concept.

Referring to FIG. 3, a main board 105' may include a socket 210, a fixing unit 220, and a shield 230.

Constitutions and operations of the socket 210 and the fixing unit 220 are referred to the above explanation with reference to FIG. 2, and these will not be repeatedly explained for the sake of brevity.

As designs of electronic apparatuses become thinner and lighter, antennas of wireless devices, such as WiFi, and resources of RF noises (e.g., memory chip or memory module mounted on a main board) become physically arranged within closer distances to each other than in conventional electronic apparatuses, and this closer disposition cause problems such as RFI noises. Specifically, as speed of recent memory module increases (e.g., operation speed of DDR3-1600, which is in mathematical terms its basic frequency *3 = 800 Mhz*3 = 2.4 Ghz), interference with a WiFi antenna having 2.4 Ghz bandwidth may occur, which results in deteriorating performance of WiFi communication.

On this point, an electronic apparatus 100, according to a second embodiment of the present general inventive concept, includes the shield 230 formed on the main board 105' of the electronic apparatus 100 to shield the memory module 300 on the upper portion of the socket 210 and the fixing unit 220, to which the memory module 300 is mounted, so as to cancel out such interference. The shield 230 may preferably be made from metal to block electromagnetic waves.

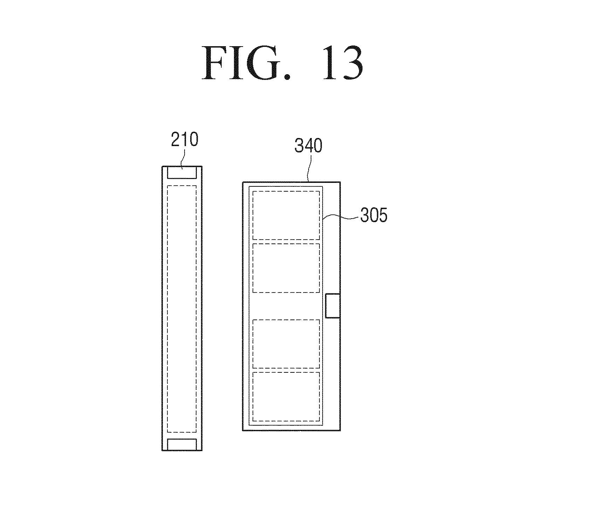

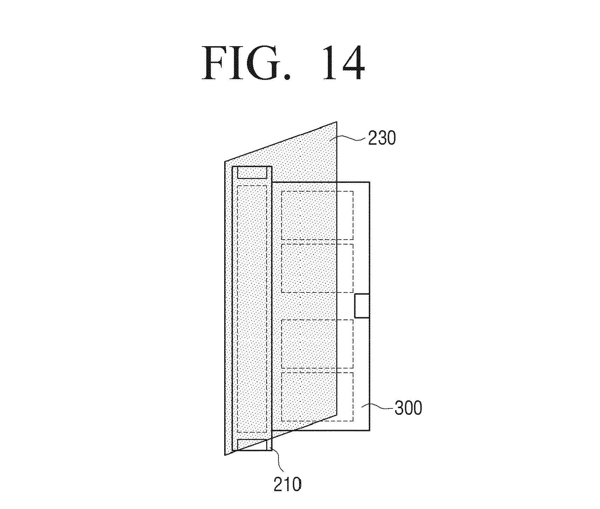

Meanwhile, the shield 230 may be formed on the electronic apparatus 100, as illustrated in FIGS. 3 and 14, or on the memory module 300 as illustrated in FIG. 13. Further, a shield may be formed on both the electronic apparatus 100 and the memory module 300.

Meanwhile, if the shield 230 is formed on the main board 105' of the electronic apparatus 100, the shield 230 may preferably be arranged to be separated from, and attachable to, the main board 105' of the electronic apparatus 100. Specifically, if the shield 230 is fixed, the memory module 300 is not detachable from the electronic apparatus 100. Accordingly, referring to FIG. 14, the shield 230 may rotate on one side of the socket 210 (or around the socket 210) and may be fixed to the memory module 300 via the fixing unit 220.

The above electronic apparatus 100, according to an embodiment of the present general inventive concept, can reduce RFI noises that can occur between the memory module 300 and communication devices by covering an upper portion of the memory module 300 with the shield.

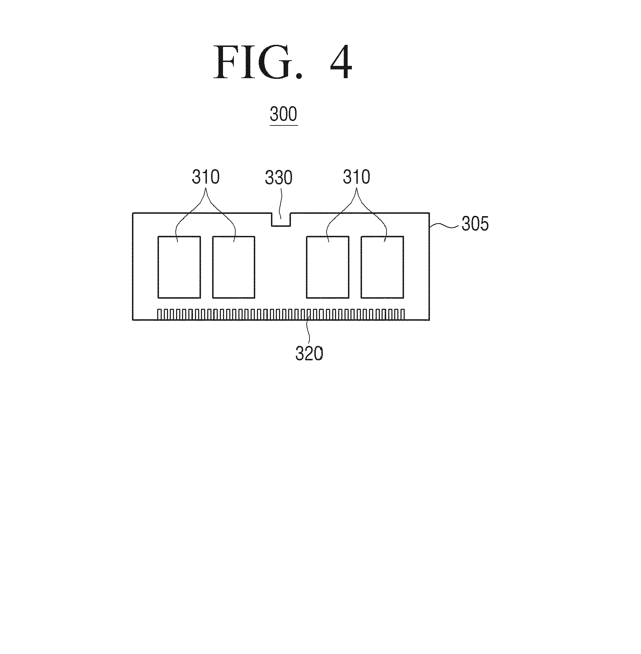

FIG. 4 illustrates a circuit board of memory module according to a first embodiment of the present general inventive concept.

Referring to FIG. 4, a memory module 300 may include a circuit board 305, a memory portion comprising a plurality of memory chips 310, a terminal 320, and a connecting portion 330.

The circuit board 305 is a printed circuit board (PCB) where components such as the plurality of memory chips 310 are mounted. The circuit board 305 is a dual side PCB having conductive layers on both sides. Meanwhile, while dual side PCB may be used in one embodiment, in another embodiment, a single side PCB having conductive layer on one side may also be implemented.

The circuit board 305 may have horizontal length of 50 mm to 60 mm (specifically, 55.2 mm), vertical length of 15 mm to 25 mm (specifically, 21.8 mm) and thickness of less than 0.7mm(here, thickness is that of the circuit board.) Since widely used SO-DIMM memory devices typically have a size of 67.6 x 30 mm, the memory module 300 of an embodiment of the present general inventive concept may have this typical size reduced by 40 % when compared to conventional memory modules. Meanwhile, when a memory module is arranged on a circuit board, the memory module and the circuit board where the memory module is arranged may have thickness (thickness of the memory module (300)) of 3 mm to 4 mm.

The memory portion includes a plurality of memory chips 310 arranged on the circuit board 305. Specifically, a plurality of memory chips 310 may be placed on one side of the circuit board 305, or on both sides of the circuit board 305. Memory capacity of the memory portion may be variously implemented according to capacity and number of included memory chips 310. For example, if capacity of the memory module is 8 Gb, then 8 memory chips having 4 Gb may be placed and implemented on both sides of the circuit board 305. In addition, 4 memory chips having 8 Gb may be placed on one side, or 4 memory chips having 8 Gb may be placed on both sides by arranging 2 memory chips per one side of the circuit board 305.

The terminal 320 interfaces between the electronic apparatus 100 and the plurality of memory chips 310, and is arranged on one side of the circuit board 305. Specifically, the terminal 320 is arranged on the side of the circuit board 305 to be mounted on the socket 210 of the main board 105. The illustrated example of FIG. 4 shows the terminals 320 placed on one side of the circuit board 305. However, the terminals 320 may be arranged on a different side of the circuit board 305.

The widely used SO-DIMM memory device currently utilizes 204 terminals. However, considering that not all 204 terminals are used, the terminals 320 according to an embodiment of the present general inventive concept may have 204 terminals, as conventionally implemented, or 170 to 185 terminals such that unnecessary terminals are excluded. The terminals may be spaced apart at 5 mm intervals, as in conventional SO-DIMM memory devices, or at other intervals. Specifically, to reduce a length of the total size of the terminals 320, the terminals may be spaced apart at 4 mm intervals. Meanwhile, in this embodiment, it is explained that the terminal 320 may have 170-185 terminals, but the terminal 320 may also have 185-200 terminals.

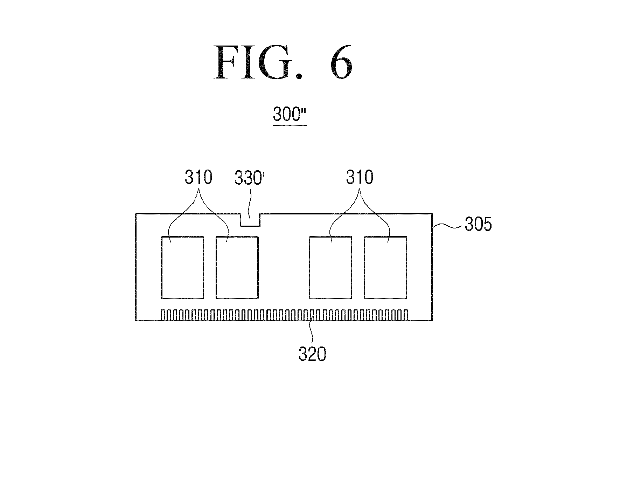

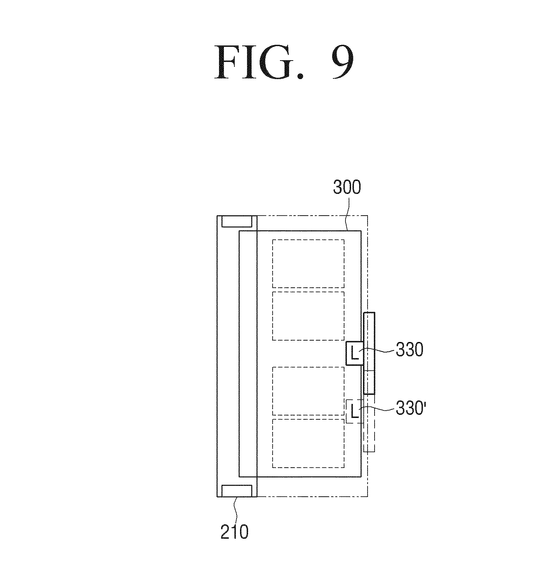

The connecting portion 330 may be placed on one side of the circuit board 305 to face the terminal 320. Specifically, the connecting portion 330 may be connected to the fixing unit 220 of the electronic apparatus 100 to fix the memory module 300 to the electronic apparatus 100, and may be provided in the form of a groove of a preset size as illustrated in FIG. 4. The position of the connecting portion 330 may correspond to types of memory modules that can attach to an electronic apparatus and this will be explained in detail below by referring to FIGS. 6 and 9. Since the connecting portion 300 is placed on only one side of the circuit board 305, less area on the circuit board is occupied when compared to conventional latch structures in which a connecting portion is arranged on both sides. The memory module type may be DDR3 or low power DD3, but not limited thereto.

The memory module according to an embodiment of the present general inventive concept utilizes a circuit board having small size, and thus may be implemented to be in smaller size.

Further, by utilizing a latch structure formed on both sides of a circuit board and a connecting portion disposed on only one side of the circuit board, the size of the memory module 300 may be greatly reduced.

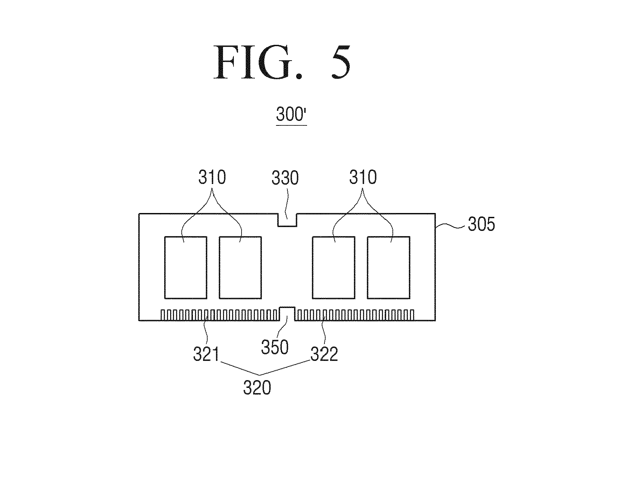

FIG. 5 illustrates a circuit board of memory module according to a second embodiment of the present general inventive concept.

Specifically, a memory module 300' according to the second embodiment of the present general inventive concept may include a key area 350 to divide types of memory modules.

Referring to FIG. 5, the memory module 300' may include a circuit board 305, a memory portion comprising a plurality of memory chips 310, a terminal 320, a connecting portion 330 and the key area 350.

The circuit board 305, the memory portion comprising a plurality of memory chips 310, and the connecting portion 330 have the same constitutions and operations as described above with reference to FIG. 4, and thus will not be further explained for the sake of brevity.

The terminal 320 includes a first terminal 321 and a second terminal 322.

The first terminal 321 includes a plurality of terminals spaced apart at same intervals on an upper surface of the circuit board 305. The plurality of terminals may be spaced apart at 5 mm intervals, as in the case of conventional SO-DIMM memory devices, or spaced apart at 4 mm intervals to reduce size of the first terminal 321.

The second terminal 322 includes a plurality of terminals spaced apart at same intervals on the upper surface of the circuit board 305. The plurality of terminals may be spaced apart at 5 mm intervals, as in the case of conventional SO-DIMM memory devices, or spaced apart at 4 mm intervals to reduce size of the second terminal 322.

Meanwhile, since position of the key area 350 may be modified according to types of memory devices, the number of terminals included in the first terminal 321 and the number of terminals included in the second terminal 322 may change. However, a total number of terminals of the first terminal 321 and the second terminal 322 is the same, as illustrated in FIG. 4, even when the key area 350 is provided as illustrated in FIG. 5. Specifically, 204 terminals may be provided, as in the case of conventional SO-DIMM memory devices, or 170 to 200 terminals may be provided such that unnecessary elements from 204 terminals are excluded.

If the terminals 320 are implemented as illustrated in FIG. 4, in other words if key area 350 is not provided, the interval between a terminal of the first terminal 321 and an adjacent terminal of the second terminal 322 is the same interval as the interval between a plurality of terminals of the first (or second) terminal.

The key area 350 may be formed in the first terminal 321 and the second terminal 322.

Specifically, the key area 350 may be implemented in the form of a groove of a preset size and disposed in a position so as to divide types of memory modules. Further, the key area 350 may be used to divide a direction of mounting the memory module (i.e., upper/lower positions of memory module), and thus the key area 350 may be placed at a deviated position of the circuit board 305, as illustrated in FIG. 6, instead of being placed at a center of one side of the circuit board 305 as illustrated in FIG. 5.

According to an embodiment of the present general inventive concept, the key area 350 is used to divide types of memory modules. However, depending on embodiments, the connecting portion 330 may perform the function of the key area 350 of FIG. 5. This embodiment will be explained in detail below by referring to FIG. 6.

FIG. 6 illustrates a circuit board of a memory module 300" according to a third embodiment of the present general inventive concept.

Specifically, in the memory module 300" according to the third embodiment, a connecting portion 330' performs functions of conventional key areas.

Referring to FIG. 6, the memory module 300" may include a circuit board 305, a memory portion comprising a plurality of memory chips 310, a terminal 320, and a connecting portion 330'.

The connecting portion 330' is placed on one side of the circuit board 305 to face the terminal 320. Specifically, the connecting portion 330' is connected to the fixing unit 220 of the electronic apparatus 100 to fix the memory module 300" to the electronic apparatus 100. The position of the connecting portion 330' may correspond to types of memory modules that can be attached to the electronic apparatus 100. Meanwhile, the connecting portion 330' may be used to divide the direction of mounting memory module (i.e., upper/lower positions of memory module), and thus, the connecting portion 330' may be placed at a deviated position, as illustrated in FIG. 6, rather than being placed at a center of one side of the circuit board 305, as illustrated in FIG. 5, and the placement of the connecting portion 330' may vary according to types of memory modules.

As explained above, since the connecting portion 330' performs functions of conventional latch structures and key structures, the size of the memory module may be further reduced according to the third embodiment of the present general inventive concept.

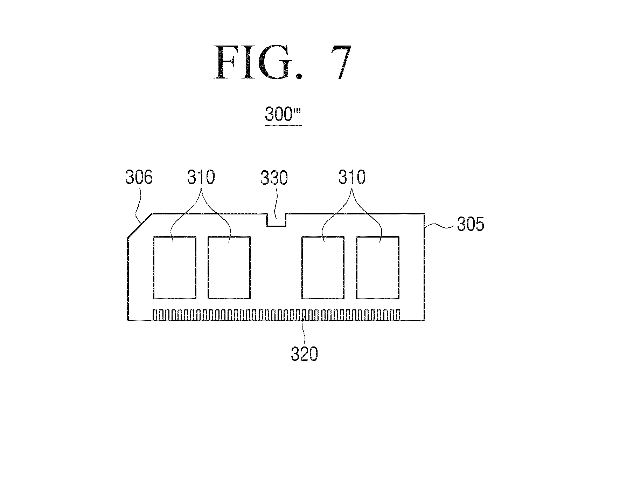

FIG. 7 illustrates a circuit board of a memory module according to a fourth embodiment of the present general inventive concept.

Specifically, the memory module 300"' according to the fourth embodiment further includes an edge groove 306.

By referring to FIG. 7, the memory module 300"' may include a circuit board 305, a memory portion comprising a plurality of memory chips 310, a terminal 320, a connecting portion 330, and an edge groove 306.

Since the circuit board 305, the memory portion comprising a plurality of memory chips 310, the terminal 320, and the connecting portion 330 have the same constitutions and operations as explained above with reference to FIG. 4, these will not be repeatedly explained below for the sake of brevity.

The edge groove 306 is an area to indicate the direction of arranging the circuit board 305 on the electronic apparatus 100. Specifically, as illustrated in FIG. 7, the edge groove 306 may be one apex area of the circuit board 305 (preferably, one side where the connecting portion 330 is formed) which may be implemented to be cut to a triangle shape (or groove shape). Alternatively, the edge groove 306 may be disposed on a side of the circuit board 305 that is different to the side where the connecting portion 330 is formed.

The edge groove 306 may be applied to the memory modules 300 according to each embodiment of the present general inventive concept.

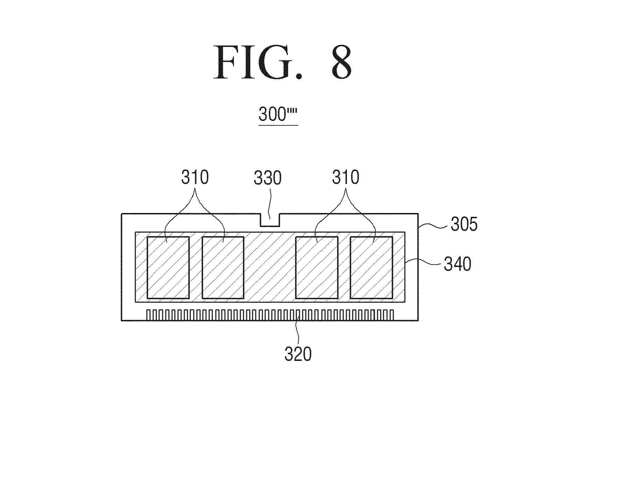

FIG. 8 illustrates a circuit board of a memory module according to a fifth embodiment of the present general inventive concept.

Specifically, a memory module 300"" according to the fifth embodiment of the present general inventive concept further includes a shield 340.

Referring to FIG. 8, the memory module 300"" may include a circuit board 305, a memory portion comprising a plurality of memory chips 310, a terminal 320, a connecting portion 330, and the shield 340.

Since the circuit board 305, the memory portion comprising a plurality of memory chips 310, the terminal 320, and the connecting portion 330 have the same constitutions and operations as explained above with reference to FIG. 4, these will not be repeatedly explained below for the sake of brevity.

The shield 340 seals an upper portion of a circuit board 305. Specifically, the shield 340 is formed from a metal material and may be placed on an upper portion of the memory chips 310 to reduce RFI noises between the memory module 300"" and the electronic apparatus 100.

Meanwhile, while certain embodiments of the present general inventive concept illustrated herein describes that the shield 340 is only arranged on an upper portion of thecircuit board 305, alternative arrangements are possible. Accordingly, if memory chips 310 are placed on both sides of the circuit board 305, the shield 340 may be arranged on both sides of the circuit board 305 as well.

Further, although certain embodiments of the present general inventive concept describes that the shield 340 is only arranged on an upper portion of the memory portion comprising a plurality of memory chips 310, alternative arrangements are also possible. Accordingly, the shield 340 may be implemented to cover the entire area of atop surface area, and/or a bottom surface area, of the circuit board 305 excluding the terminal 320.

As explained above, the shield 340 is arranged to cover an upper portion of the memory module 300"", and thus, RFI noises that can occur between the memory module 300"" and communication devices may be reduced.

FIG. 9 is a view provided to explain an operation of a connecting portion of a memory module according to an embodiment of the present general inventive concept.

Specifically, a connecting portion 330 may perform functions of conventional latch structures and key structures, as explained above with reference to FIGS. 4 and 6. For example, if the memory chip is a DDR3, the connecting portion 330 may be placed on the center of one side of the circuit board 305. If the memory chip is a low power DDR3, the connecting portion 330' may be placed at a different area than the center of one side of the circuit board 305, as illustrated in FIG. 9.

FIGS. 10 to 12 are views provided to explain operation of a connecting portion between the memory module 300 and the electronic apparatus 100 according to an embodiment of the present general inventive concept.

Referring to FIG. 10, one side of the memory module 300 (where the terminals are arranged) is fixed by the socket 210 of the electronic apparatus 100, and the other side of the memory module (where the connecting portion is formed) is fixed by the fixing unit 220 of the electronic apparatus 100.

Referring to FIG. 11, one side of the memory module 300 is first fixed to the socket 210 of the electronic apparatus 100, while the memory module 300 is rotated with the socket 210, another side of the memory module 300(more specifically, a connection portion 330) presses a umbrella shaped fastening unit 220. As the memory module presses the umbrella shaped fastening unit 220, the umbrella shaped fastening unit 220 changes to a shape with a narrower width. As the width of the umbrella shaped fastening unit 220 is narrower, the connection portion 330 of the memory module passes through the umbrella shaped fastening unit 220. When the connection portion 330 passes through the umbrella shaped fastening unit 220, the umbrella shaped fastening unit 220 returns to an original shape and then makes another side of the memory module 300 fixed.

When a user is to separate the arranged memory module, width of the umbrella shaped fastening unit 220 becomes narrower by pressing a lever 221 arranged at a side of the umbrella shaped fastening unit 220, and the memory module 300 and the fixing unit 220 may be separated.

Meanwhile, although FIGS. 10 and 11 illustrate that the fixing unit 220 is implemented by using an umbrella shaped fastening means, the fixing unit 220 may be implemented by using another fastening means that comprises a different shape than the umbrella shaped fastening means illustrated in FIGS. 10 and 11, so long as the fixing unit 220 fixes the memory module 300 to the electronic apparatus 100.

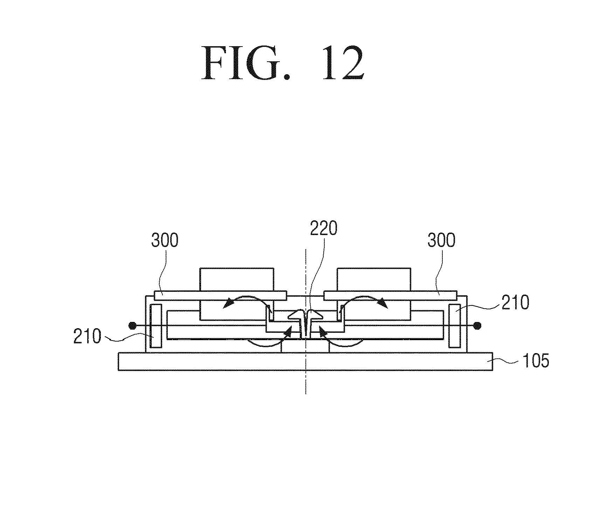

Further, although above embodiments of the present general inventive concept describe that one memory module 300 may be formed on the main board 105 of the electronic apparatus 100, two memory modules may be formed on the main board 105 of the electronic apparatus 100, as illustrated in FIG. 12. In addition, depending on embodiments of the present general inventive concept, the electronic apparatus 100 may have more than three memory modules 300 mounted thereon.

Although FIGS. 10 to 12 do not specifically show other components that may be arranged on an area of the main board 105 of the electronic apparatus 100 where the memory module 300 is mounted, depending on embodiments of the present general inventive concept, general electric devices, such as a resistor, a capacitor, or a transistor, may also be arranged on the main board 105 of the electronic apparatus 100, or a plurality of memory chips 310 may also be included on the main board 105 of the electronic apparatus 100. Accordingly, the memory portion occupies less area on the main board 105 of the electronic apparatus 100.

Although a few embodiments of the present general inventive concept have been shown and described, it will be appreciated by those skilled in the art that changes may be made in these embodiments without departing from the principles of the invention, the scope of which is defined in the appended claims.

## Claims

1. A memory apparatus mountable on an electronic apparatus, comprising:
a circuit board;
a memory portion comprising a plurality of memory chips arranged on the circuit board;
a terminal arranged on a first side of the circuit board to provide an interface between the electronic apparatus and the plurality of memory chips; and
a connecting portion arranged on a second side of the circuit board to face the terminal, the connecting portion being connectable to a fixing unit of the electronic apparatus to fix the memory apparatus to the electronic apparatus.

2. The memory apparatus of claim 1, wherein the circuit board has horizontal length of 50 mm to 60 mm and a vertical length of 15 mm to 25 mm.

3. The memory apparatus of claim 1 or 2, wherein the thickness of the memory portion and the circuit board where the memory portion is arranged is 3 mm to 4 mm.

4. The memory apparatus of any of claims 1 to 3, wherein the terminal comprises:
a first terminal comprising a plurality of terminals spaced apart at uniform intervals on an upper portion of the circuit board; and
a second terminal comprising a plurality of terminals spaced apart at uniform intervals on an upper portion of the circuit board.

5. The memory apparatus of any of claims 1 to 4, wherein the interval between the plurality of terminals of the first terminal, and the interval between the plurality of terminals of the second terminal, are 0.5 mm, respectively.

6. The memory apparatus of claim 4 or 5, wherein the first terminal and the second terminal are spaced apart from each other.

7. The memory apparatus of claim 6, wherein the first terminal and the second terminal are intervened with a groove formed therebetween.

8. The memory apparatus of any one of claims 4 to 7, wherein an interval between a terminal of the first terminal and an adjacent terminal of the second terminal is the same interval as the interval between the plurality of terminals of the first terminal.

9. The memory apparatus of any of the preceding claims, wherein the terminal comprises a plurality of terminals and the number of plurality of terminals are 170 to 200 terminals.

10. The memory apparatus of any of the preceding claims, wherein the connecting portion is implemented as a groove of a preset size on the second side of the circuit board.

11. The memory apparatus of any of the preceding claims, wherein a position of the connecting portion corresponds to types of memory modules attachable to the electronic apparatus.

12. The memory apparatus of any one of the preceding claims, wherein the plurality of memory chips are arranged on the same side surface of the circuit board.

13. The memory apparatus of any of the preceding claims, further comprising a shield which seals an upper portion of the circuit board.

14. The memory apparatus of claim 13, wherein the shield is formed from a metal.

15. An electronic apparatus to or from which a memory module is attachable or detachable, comprising:
a socket comprising a plurality of terminals connected electrically to the memory module;
a fixing unit to fix the memory module to the electronic apparatus; and
a shield to remove noises of the memory module,
wherein the shield is separable from the electronic apparatus, and fixed by the fixing unit.
